# EUROPEAN PATENT SPECIFICATION

(11) **EP 4 521 637 B1**
(45) Date of publication and mention of the grant of the patent: **23.09.2026**
(21) Application number: 22946884.8
(22) Date of filing: 17.06.2022
(51) Int. Cl.: H03F 1/08, H03F 1/34, H03F 1/22, H03F 1/42, H03F 3/193

(54) **FEEDBACK AMPLIFIER**
RÜCKGEKOPPELTER VERSTÄRKER
AMPLIFICATEUR À RÉTROACTION

(43) Date of publication of application: 12.03.2025
(73) Proprietor: MITSUBISHI ELECTRIC CORPORATION, Chiyoda-ku Tokyo 100-8310 (JP)
(72) Inventor: KUDARA, Ken, Tokyo 100-8310 (JP); KAMIOKA, Jun, Tokyo 100-8310 (JP)
(74) Representative: Pfenning, Meinig & Partner mbB
(86) International application number: PCT/JP2022/024252
(87) International publication number: WO 2023/243068

(56) References cited:
- CA-A1- 2 342 175
- CN-U- 212 231 409
- JP-A- H0 983 269
- JP-A- H05 110 343
- JP-A- H08 162 859
- KR-A- 20180 029 787
- US-A1- 2007 139 117
- HSIEN-KU CHEN ET AL: "A Compact Wideband CMOS Low-Noise Amplifier Using Shunt Resistive-Feedback and Series Inductive-Peaking Techniques", IEEE MICROWAVE AND WIRELESS COMPONENTS LETTERS, IEEE SERVICE CENTER, NEW YORK, NY, US, vol. 17, no. 8, 1 August 2007 (2007-08-01), pages 616 - 618, XP011189453, ISSN: 1531-1309, DOI: 10.1109/LMWC.2007.901797

## Description

### TECHNICAL FIELD

The present disclosure relates to a feedback amplifier.

### BACKGROUND ART

A feedback amplifier is a type of amplifiers which amplify a high frequency signal received by a wireless communication device, and provides good impedance matching over a wide band. For example, a feedback amplifier which employs a high electron mobility transistor (HEMT) is described in Nonpatent Literature 1. In this amplifier, the amount of feedback of a voltage is reduced by connecting an inductance to the drain terminal of a transistor for amplification, and the gain flatness in a wide band is ensured by improvement in gain in a high frequency range.
CN212231409U discloses an active bias integrated circuit broadband low noise amplifier, comprising a PHEMT amplification tube core, a source electrode matching circuit, an active bias circuit, aninput matching circuit, an output matching circuit and a negative feedback circuit, the PHEMT amplification tube core FET1, the source electrode matching circuit and the active bias circuit are integrated on a GaAs chip; the input matching circuit, the output matching circuit and the negative feedback circuit are composed of discrete devices.
CA2342175A1 discloses a microwave amplifier comprising an inductor and a resistor, which are connected in parallel between the source electrode of a field-effect transistor and ground. The inductor resonates at resonance frequency fo because it has a parasitic component B. Since the source electrode of the field-effect transistor is grounded through the resistor connected in parallel with the inductor, however, the field-effect transistor operates normally even if resonance makes the inductor open.
HSIEN-KU CHEN ET AL: "A Compact Wideband CMOS Low-Noise Amplifier Using Shunt Resistive-Feedback and Series Inductive-Peaking Techniques", IEEE MICROWAVE AND WIRELESS COMPONENTS LETTERS, IEEE SERVICE CENTER, NEW YORK, NY, US, vol. 17, no. 8, 1 August 2007 (2007-08-01), pages 616-618 discloses a wideband CMOS low-noise amplifier (LNA) that employs shunt resistive-feedback and series inductive-peaking techniques to enhance bandwidth and noise performance.
US2007139117A1discloses a wide-band amplifier having a flat amplification characteristic over a wide frequency bandwidth, being prevented from degrading due to parasitic capacitance, and being short in group delay time. The wide-band amplifier includes a band-pass filter made of an LC parallel resonant circuit and an LCR series resonant circuit and provided in parallel as a load for a current output amplifier device.

### CITATION LIST

### NONPATENT LITERATURE

Nonpatent Literature 1: Mingqi Chen et al, "A1-25 GHz GaN HEMT MMIC Low-Noise Amplifier," IEEE MICROWAVE AND WIRELESS COMPONENTS LETTERS, VOL. 20, NO. 10, OCTOBER 2010.

### SUMMARY OF INVENTION

### TECHNICAL PROBLEM

A problem with the conventional feedback amplifier described in Nonpatent Literature 1 is that the amplification characteristic becomes unstable in a range of high frequencies (referred to as a high frequency range hereinafter), e.g. a range of frequencies greater than or equal to several tens of GHz, as the inductance value loaded in the drain terminal of the transistor is increased.

The present disclosure is made to solve the above-mentioned problem, and it is therefore an object of the present disclosure to provide a feedback amplifier that provides a high-gain low-noise-index characteristic, and that can prevent its amplification characteristic from becoming unstable in a high frequency range.

### SOLUTION TO PROBLEM

The invention is defined in the appended set of claims. A feedback amplifier according to the present disclosure includes: an amplification transistor which has a control terminal connected to an input terminal, and has a first terminal and a second terminal, and in which conductance between the first and second terminals is controlled by a DC voltage inputted to the control terminal, and the first terminal is grounded; a first feedback circuit to provide negative feedback for a path between the control and second terminals of the amplification transistor; a second feedback circuit provided in a path between an output terminal and the second terminal of the amplification transistor, and connected in series to the first feedback circuit, to provide, via the first feedback circuit, positive feedback for the path between the control and second terminals of the amplification transistor; and a third feedback circuit connected in series to the first feedback circuit and connected in parallel to the second feedback circuit, to adjust the stability factor of the feedback amplifier in a high frequency range outside a used frequency band, wherein an absolute value of an impedance in the third feedback circuit decreases as a frequency of an input signal becomes higher.

### ADVANTAGEOUS EFFECTS OF INVENTION

According to the present disclosure, the first feedback circuit provides the negative feedback between the control and second terminals of the amplification transistor, the second feedback circuit provides the positive feedback between the control and second terminals of the amplification transistor, and the third feedback circuit adjusts the stability factor of the feedback amplifier in the high frequency range outside the used frequency band. As a result, the feedback amplifier according to the present disclosure provides a high-gain low-noise-index characteristic, and can prevent its amplification characteristic from becoming unstable in the high frequency range.

### BRIEF DESCRIPTION OF DRAWINGS

FIG. 1 is a circuit diagram showing the configuration of a feedback amplifier according to Embodiment 1 which is not covered by the claimed invention;
FIG. 2 is a circuit diagram showing the configuration of a variant (1) of the feedback amplifier according to Embodiment 1 which is not covered by the claimed invention;
FIG. 3 is a graph showing a relation between a stability factor and frequencies;
FIG. 4 is a graph showing a relation between a gain and frequencies;
FIG. 5 is a graph showing a relation between a noise figure and frequencies;
FIG. 6 is a circuit diagram showing the configuration of a variant (2) of the feedback amplifier according to a variant of Embodiment 1 which is covered by the claimed invention;
FIG. 7 is a graph showing a relation between the absolute value of impedance and frequencies which is covered by the claimed invention; and
FIG. 8 is a circuit diagram showing the configuration of a feedback amplifier according to Embodiment 2 which is not covered by the claimed invention. Hereinafter, whenever an embodiment is described, reference is to be made to the above figure list to determine whether the embodiment is to be read as covered by the claimed invention or as an embodiment which is not covered by the claimed invention.

### DESCRIPTION OF EMBODIMENTS

### Embodiment 1.

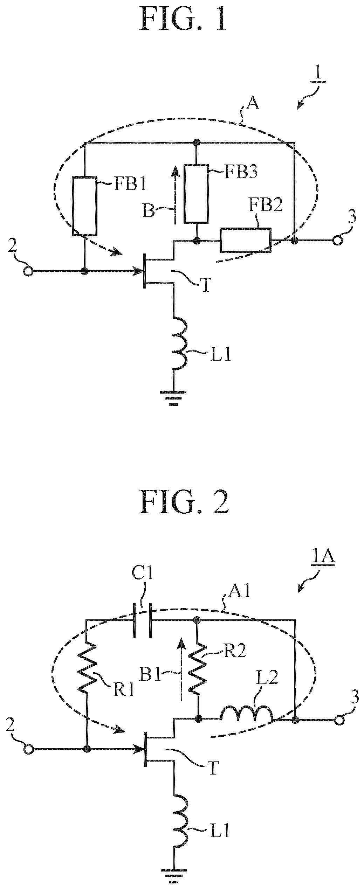

FIG. 1 is a circuit diagram showing the configuration of a feedback amplifier 1 according to Embodiment 1. The feedback amplifier 1 amplifies a high frequency signal inputted to an input terminal 2, and outputs the signal amplified thereby from an output terminal 3. The feedback amplifier 1 is a monolithic microwave integrated circuit (MMIC) amplifier, for example. The feedback amplifier 1 is configured so as to include an amplification transistor T, an inductor L1, a first feedback circuit FB1, a second feedback circuit FB2, and a third feedback circuit FB3, as shown in FIG. 1. For example, at a time of use of the feedback amplifier 1, a high frequency signal having a frequency within a used frequency band of the feedback amplifier 1 is inputted to the input terminal 2. Further, in the case where the feedback amplifier 1 is used for a wireless communication device, the used frequency band is determined by the communications standards.

The amplification transistor T has a control terminal, a first terminal, and a second terminal, and an electrical connection between the first and second terminals is made by a DC voltage inputted to the control terminal. Further, in the amplification transistor T, the first terminal is grounded via the inductor L1.

For example, in the case where the amplification transistor T is a field effect transistor (FET), the control terminal is a gate terminal, the first terminal is a source terminal, and the second terminal is a drain terminal. Further, the FET used as the amplification transistor T is a high withstand voltage one, such as a GaN (gallium nitride)-HEMT, having a source field plate, for example.

As shown in FIG. 1, the input terminal 2 is connected to the gate terminal of the amplification transistor T, and the source terminal is grounded via the inductor L1. Further, each of the second and third feedback circuits FB2 and FB3 is connected to the drain terminal. Although an illustration of a bias circuit and so on is omitted in FIG. 1, it is assumed that a proper DC voltage is applied to the gate and drain terminals in such a way that the FET used as the amplification transistor T has an amplification action.

The first feedback circuit FB1 provides negative feedback between the gate and drain terminals of the amplification transistor T. For example, the first feedback circuit FB1 includes an element having a resistive property. For example, the element having a resistive property is a resistor which provides an amount of negative feedback in a low frequency range within the used frequency band.

The second feedback circuit FB2 is disposed between the output terminal 3 and the drain terminal of the amplification transistor T, and is connected in series to the first feedback circuit FB1. At frequencies within the used frequency band, the second feedback circuit FB2 provides positive feedback, via the first feedback circuit FB1, between the gate and drain terminals of the amplification transistor T, as shown by a dashed arrow A in FIG. 1. For example, the second feedback circuit FB2 includes an element having a reactive property. The element having a reactive property is an inductor connected in series between the drain terminal of the amplification transistor T and the output terminal 3, for example.

The third feedback circuit FB3 is connected in series to the first feedback circuit FB1 and is connected in parallel to the second feedback circuit FB2, and is intended for adjusting the stability factor of the feedback amplifier 1 in a high frequency range outside the used frequency band. By using the third feedback circuit FB3 which adjusts the stability factor of the feedback amplifier 1 to a desired value, the amplification characteristic in the high frequency range outside the used frequency band is stabilized between the drain terminal of the amplification transistor T and the first feedback circuit FB1, as shown by an alternating long and short dashed arrow B in FIG. 1. For example, the third feedback circuit FB3 includes an element having a resistive property. The element having a resistive property is a resistor connected between the drain terminal of the amplification transistor T and the first feedback circuit FB1, for example.

Next, a concrete configuration of the feedback amplifier according to Embodiment 1 will be explained.

FIG. 2 is a circuit diagram showing the configuration of a feedback amplifier 1A which is a variant (1) of the feedback amplifier 1. The feedback amplifier 1A embodies the circuit configuration of the feedback amplifier 1, and, for example, is a MMIC amplifier. In FIG. 2, a series circuit in which a resistor R1 and a capacitor C1 are connected in series is the first feedback circuit FB1 shown in FIG. 1. More specifically, the first feedback circuit FB1 included in the feedback amplifier 1A includes the resistor R1 as an element having a resistive property.

An inductor L2 is the second feedback circuit FB2 shown in FIG. 1. More specifically, the second feedback circuit FB2 included in the feedback amplifier 1A includes the inductor L2 as an element having a reactive property. A resistor R2 is the third feedback circuit FB3 shown in FIG. 1. More specifically, the third feedback circuit FB3 included in the feedback amplifier 1A includes the resistor R2 as an element having a resistive property.

The resistor R1 is a feedback one which provides an amount of negative feedback in the used frequency band. As the resistor R1, a resistor having a resistance value (e.g. 300Ω) which causes the input and output impedances of the feedback amplifier 1A to have proper values is used in order to improve the reflection characteristics of the input and output of the feedback amplifier 1A. Further, in order to sufficiently provide the feedback amount in the low frequency range within the used frequency band, a capacitor having an impedance value which is approximately 1/10th or less that of the resistor R1 is used as the capacitor C1.

Further, the capacitor C1 is used as a DC cut one which blocks a direct current (DC) flowing between the gate and drain terminals of the amplification transistor T. The feedback amplifier 1A does not need to include the capacitor C1 as long as there is no influence on the DC bias of the amplification transistor T, i.e., as long as the direct current flowing between the gate and drain terminals falls within an allowable range.

The first feedback circuit FB1 may be the one in which an inductor is connected in series to the series circuit of the resistor R1 and the capacitor C1. Even the first feedback circuit FB1 configured in this way can provide negative feedback between the gate and drain terminals of the amplification transistor T. More specifically, any arbitrary component can be added to or eliminated from the first feedback circuit FB1 in Embodiments 1 and 2 as long as the first feedback circuit FB1 has the configuration of providing negative feedback between the gate and drain terminals of the amplification transistor T.

The inductor L2 is connected in series between the drain terminal of the amplification transistor T and the output terminal 3, and is a component in an impedance matching circuit of the feedback amplifier 1A. By changing the inductance value of the inductor L2, it is possible to change the phase of the high frequency signal to be amplified by the amplification transistor T for each frequency.

As the inductor L2, an inductor having an inductance value which brings the phase of the high frequency signal inputted to the input terminal 2 close to that of the high frequency signal outputted from the output terminal 3 in the high frequency range outside the used frequency band is used. As a result, the inductor L2 provides positive feedback, as shown by a dashed arrow A1 in FIG. 2, so that the gain of the feedback amplifier 1A is adjusted.

For example, as the inductor L2, an inductor having an inductance value at which the inductor resonates (resonates in series) with the output capacitance Cds of the amplification transistor T at frequencies from 0.8 times to 1.2 times the frequency at a high frequency side end of the used frequency band (in a high frequency range within the used frequency band) is used. By using the inductor L2, the phase of the high frequency signal inputted to the input terminal 2 is brought close to that of the high frequency signal outputted from the output terminal 3 in the feedback amplifier 1A, and the gain of the feedback amplifier 1A rises and the noise figure of the feedback amplifier 1A is reduced.

The inductance value of the inductor L2 is larger than that of the inductor L1 connected to the source terminal of the amplification transistor T.

The second feedback circuit FB2 may be the one in which another element having a reactive property is added to the inductor L2. Even the second feedback circuit FB2 configured in this way can provide positive feedback for a path between the control and second terminals of the amplification transistor. More specifically, any arbitrary component can be added to or eliminated from the first feedback circuit FB2 in Embodiments 1 and 2 as long as the first feedback circuit FB2 has the configuration of providing positive feedback for the path between the control and second terminals of the amplification transistor.

The resistor R2 is used in order to adjust the stability factor of the feedback amplifier 1A in the high frequency range outside the used frequency band, as shown by an alternating long and short dashed arrow B1 in FIG. 2, with being placed between the drain terminal of the amplification transistor T and the first feedback circuit FB1 (capacitor C1). The stability factor is a coefficient showing the stability of the feedback amplifier 1A, and is also referred to as the K factor. There is a case in which when the value of the stability factor becomes small, the amplification characteristic of the feedback amplifier 1A becomes unstable and the feedback amplifier 1A oscillates.

Therefore, as the resistor R2, a resistor having a resistance value which causes the stability factor of the feedback amplifier 1A to have a desired value in the high frequency range outside the used frequency band is used.

The third feedback circuit FB3 may be the one in which a capacitor is connected in series to the resistor R2. Even the third feedback circuit FB3 configured in this way can adjust the stability factor of the feedback amplifier 1A in the high frequency range outside the used frequency band. More specifically, any arbitrary component can be added to or eliminated from the third feedback circuit FB3 in Embodiments 1 and 2 as long as the third feedback circuit FB3 has the configuration capable of adjusting the stability factor of the feedback amplifier 1A in the high frequency range outside the used frequency band.

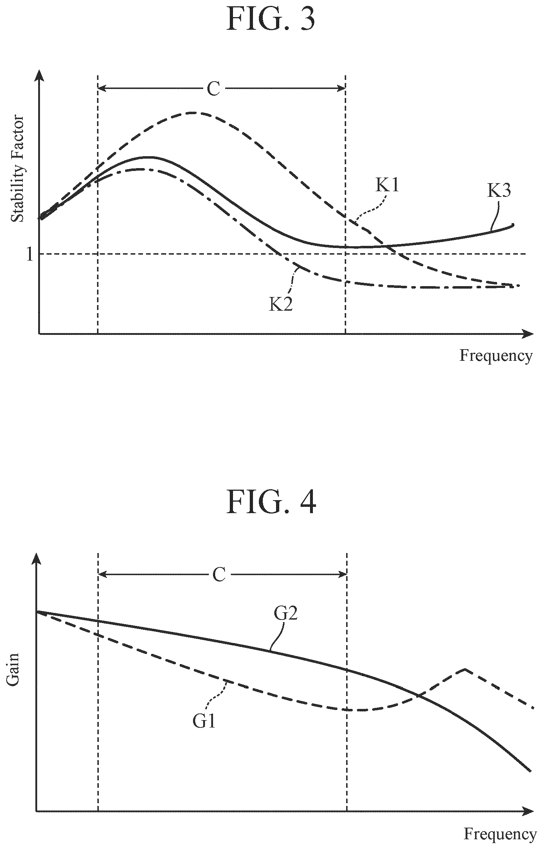

FIG. 3 is a graph showing a relation between the stability factor and frequencies, and shows the result of calculating in simulation variations in the stability factors of feedback amplifiers with respect to the frequency of an input signal in a frequency band including the used frequency band C, a low frequency side range (referred to as the low frequency range hereinafter) outside the used frequency band C, and the high frequency range outside the used frequency band C.

In FIG. 3, a broken line K1 shows variations in the stability factor associated with a circuit in which the inductor L2, among the components of the feedback amplifier 1A shown in FIG. 2, is short-circuited, and the resistor R2, among the components, is made open.

That is, this circuit is a feedback amplifier in which the inductor L2, which is the second feedback circuit FB2, and also the resistor R2, which is the third feedback circuit FB3, are excluded from the components of the feedback amplifier 1A.

An alternating long and short dashed line K2 shows variations in the stability factor associated with a circuit in which the resistor R2, among the components of the feedback amplifier 1A, is made open. That is, this circuit is a feedback amplifier in which the resistor R2, which is the third feedback circuit FB3, is excluded from the components of the feedback amplifier 1A. A solid line K3 shows variations in the stability factor of the feedback amplifier 1A. For example, the value"1" shown by the broken line extending along the horizontal axis of FIG. 3 is a desired value of the stability factor.

It is clear from the broken line K1 that the feedback amplifier which has the first feedback circuit FB1, but does not have the second feedback circuit FB2 and the third feedback circuit FB3 has an unstable amplification characteristic in which its stability factor decreases as the frequency of the input signal becomes higher in a frequency range outside the used frequency band C.

More specifically, the stability factor shown by the broken line K1 becomes less than "1" which is the desired value as the frequency of the input signal becomes higher from that at the high frequency side end of the used frequency band C (the frequency shown by the broken line described on a right-hand side of the page, out of the broken lines parallel to the vertical axis of FIG. 3).

In contrast with this, in the feedback amplifier which has the first feedback circuit FB1 and the second feedback circuit FB2, but does not have the third feedback circuit FB3, the inductor L2 provides positive feedback at the high frequency side end of the used frequency band C, so that the loss decreases. Therefore, it is clear from the alternating long and short dashed line K2 that there is a characteristic in which the variations in the stability factor are small and the stability factor is flat even when the frequency of the input signal becomes high in the high frequency range outside the used frequency band C. However, the stability factor is less than "1" which is the desired value in the frequency range outside the used frequency band C.

In the feedback amplifier 1A which has all the first feedback circuit FB1, the second feedback circuit FB2, and the third feedback circuit FB3, the third feedback circuit FB3 makes an adjustment in such a way that the stability factor in the high frequency range outside the used frequency band C has the desired value ("1" in this embodiment).

The third feedback circuit FB3 may make an adjustment in such a way that the stability factor approaches the desired value. The feedback amplifier 1A should just have a characteristic in which, in the high frequency range outside the used frequency band C, the stability factor is flat with respect to the frequency of the input signal while having a value which exceeds the desired value.

For example, a resistor having a resistance value of 600Ω is used as the resistor R2 which is the third feedback circuit FB3. As a result, it is clear from the solid line K3 that there is a characteristic in which, in the high frequency range outside the used frequency band C, the stability factor of the feedback amplifier 1A is flat with respect to the frequency of the input signal while having a value which exceeds "1", and the amplification characteristic of the feedback amplifier 1A is stabilized.

Because the feedback amplifier 1A includes the first feedback circuit FB1, the second feedback circuit FB2, and the third feedback circuit FB3, the feedback amplifier 1A can reduce the loss at the high frequency side end of the used frequency band C while ensuring the stability of the amplification characteristic in the high frequency range outside the used frequency band C.

FIG. 4 is a graph showing a relation between the gain and frequencies, and shows the result of calculating in simulation variations in the gains of feedback amplifiers with respect to the frequency of an input signal in a frequency band including the used frequency band C, the low frequency range outside the used frequency band C, and the high frequency range outside the used frequency band C. In FIG. 4, a broken line G1 shows variations in the gain of a circuit in which the inductor L2, among the components of the feedback amplifier 1A shown in FIG. 2, is short-circuited, and the resistor R2, among the components, is made open. This circuit is a feedback amplifier in which the inductor L2 and the resistor R2 are excluded from the components of the feedback amplifier 1A.

A solid line G2 shows variations in the gain of the feedback amplifier 1A. More specifically, the gain shown by the solid line G2 is the gain of the feedback amplifier 1A which operates with the stability factor shown by the solid line K3 in FIG. 3. As can be seen from FIG. 4, the feedback amplifier 1A has a gain in the used frequency band C, especially, in the high frequency range within the used frequency band C which is improved compared to the feedback amplifier having only the first feedback circuit FB1, and gain flatness in the used frequency band C which is improved compared to the feedback amplifier having only the first feedback circuit FB1.

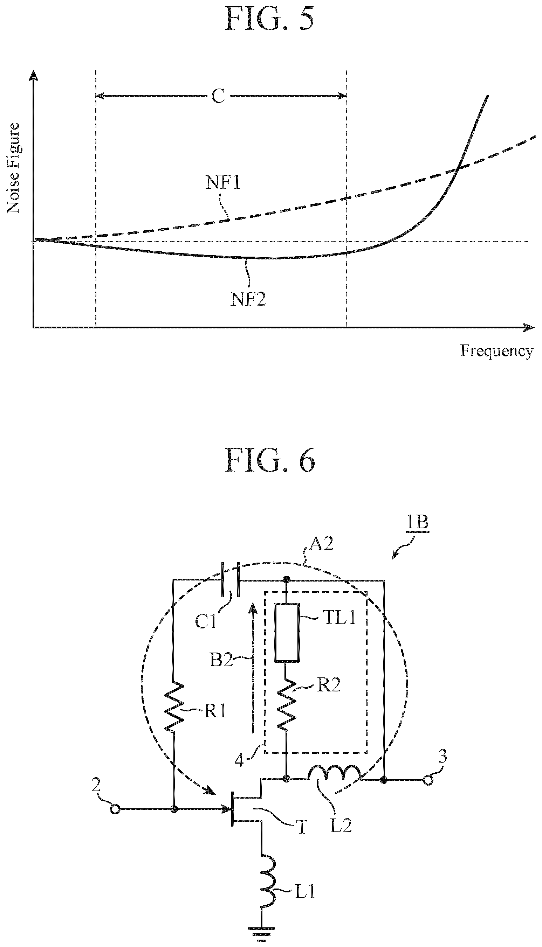

FIG. 5 is a graph showing a relation between the noise figure and frequencies, and shows the result of calculating in simulation variations in the noise figures of feedback amplifiers with respect to the frequency of an input signal in a frequency band including the used frequency band C, the low frequency range outside the used frequency band C, and the high frequency range outside the used frequency band C. The noise figure of a feedback amplifier is the ratio of the signal to noise ratio on the input side of the feedback amplifier, and the signal to noise ratio on the output side of the feedback amplifier. Further, the value of the noise figure shown by a broken line parallel to the horizontal axis of FIG. 5 is a criterion value for the noise figure in the low frequency range.

In FIG. 5, a broken line NF1 shows variations in the noise figure of a circuit in which the inductor L2, among the components of the feedback amplifier 1A shown in FIG. 2, is short-circuited, and the resistor R2, among the components, is made open. This circuit is a feedback amplifier in which the inductor L2 and the resistor R2 are excluded from the components of the feedback amplifier 1A. More specifically, the noise figure shown by the broken line NF1 is the noise figure of the feedback amplifier which operates with the stability factor shown by the broken line K1 in FIG. 3, and which has the gain shown by the broken line G1 in FIG. 4.

A solid line NF2 shows variations in the noise figure of the feedback amplifier 1A. More specifically, the noise figure shown by NF2 is the noise figure of the feedback amplifier 1A which operates with the stability factor shown by the solid line K3 in FIG. 3, and which has the gain shown by the solid line G2 in FIG. 4. As can be seen from FIG. 5, in the feedback amplifier 1A, the inductor L2 which is the second feedback circuit FB2 provides positive feedback at the high frequency end of the used frequency band C (the frequency shown by a broken line described on a right-hand side of the page, out of broken lines parallel to the vertical axis of FIG. 5). As a result, a high frequency signal having the frequency at the high frequency end and sent from the input side of the feedback amplifier 1A to the output side of the feedback amplifier 1A is eliminated, and the noise figure shown by NF2 decreases.

In the feedback amplifier 1A, although there occurs a loss due to the resistor R2 which is the third feedback circuit FB3, the loss is eliminated by the effect of the inductor L2, and the feedback amplifier 1A has a noise figure as shown by the solid line NF2. By thus providing the feedback amplifier 1A with a loss in the high frequency range outside the used frequency band C, the amplification characteristic of the feedback amplifier 1A is stabilized, and, by decreasing the loss in the used frequency band C, the gain in the used frequency band C of the feedback amplifier 1A is improved and the gain flatness of the feedback amplifier 1A can be ensured.

Next, the reason why the third feedback circuit provides a loss mainly in the high frequency range outside the used frequency band will be explained using a variant of the feedback amplifier according to Embodiment 1.

FIG. 6 is a circuit diagram showing the configuration of a feedback amplifier 1B which is a variant (2) of the feedback amplifier 1. The feedback amplifier 1B embodies the circuit configuration of the feedback amplifier 1, and, for example, is a MMIC amplifier. In FIG. 6, a series circuit in which a resistor R1 and a capacitor C1 are connected in series is the first feedback circuit FB1 shown in FIG. 1. More specifically, the first feedback circuit FB1 included in the feedback amplifier 1B includes the resistor R1 as an element having a resistive property.

An inductor L2 is the second feedback circuit FB2 shown in FIG. 1. More specifically, the second feedback circuit FB2 included in the feedback amplifier 1B includes the inductor L2 as an element having a reactive property. As the inductor L2, an inductor having an inductance value which brings the phase of the high frequency signal inputted to the input terminal 2 close to that of the high frequency signal outputted from the output terminal 3 in the high frequency range outside the used frequency band is used. As a result, the inductor L2 provides positive feedback as shown by a dashed arrow A2 in FIG. 6, so that the gain of the feedback amplifier 1B is adjusted.

A series circuit 4 in which a resistor R2 and a transmission line TL1 are connected in series is the third feedback circuit FB3 shown in FIG. 1. More specifically, the third feedback circuit FB3 included in the feedback amplifier 1B includes the resistor R2 and the transmission line TL1 as an element having a resistive property. The series circuit 4 is used in order to adjust the stability factor of the feedback amplifier 1B in the high frequency range outside the used frequency band, as shown by an alternating long and short dashed arrow B2 in FIG. 6, with being placed between the drain terminal of the amplification transistor T and the first feedback circuit FB1 (capacitor C1). The series circuit 4 also functions as a stabilization circuit which stabilizes the amplification of a high frequency signal.

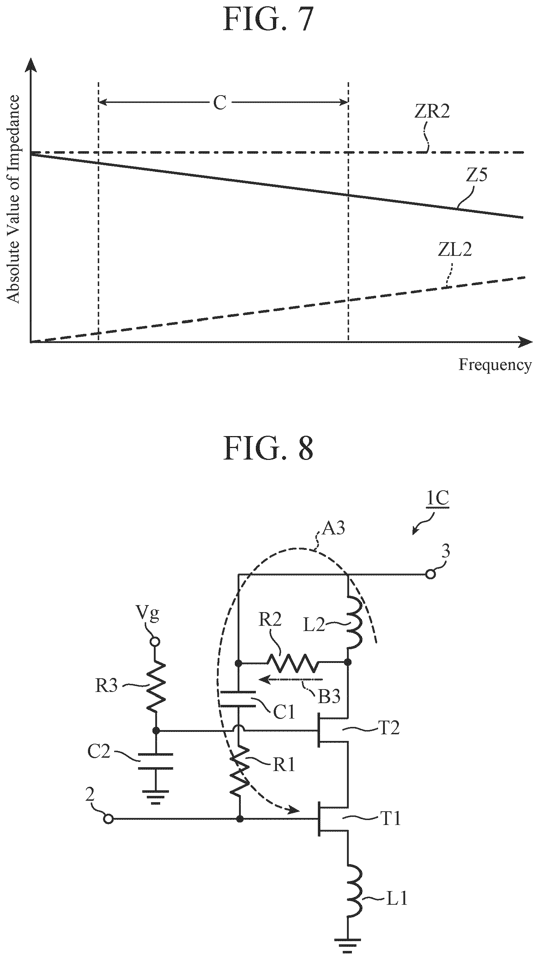

FIG. 7 is a graph showing a relation between the absolute value of impedance and frequencies, and shows the result of calculating in simulation variations in the absolute values of the impedances of feedback amplifiers with respect to the frequency of an input signal in a frequency band including the used frequency band C, the low frequency range outside the used frequency band C, and the high frequency range outside the used frequency band C.

In FIG. 7, a broken line ZL2 shows the absolute value of the impedance of the inductor L2 which is the second feedback circuit FB2 included in the feedback amplifier 1A or 1B shown in FIG. 2 or 6. An alternating long and short dashed line ZR2 shows the absolute value of the impedance of the resistor R2 which is the third feedback circuit FB3 included in the feedback amplifier 1A.

A solid line Z5 shows the absolute value of the impedance of the series circuit 4 which is the third feedback circuit FB3 included in the feedback amplifier 1B, and in which the resistor R2 and the transmission line TL1 are connected in series.

ZL2, ZR2, and Z5 show the results of calculating in simulation the absolute values of the impedances of the inductor L2, the resistor R2, and the series connection of the resistor R2 and the transmission line TL1, respectively.

It is clear from the broken line ZL2 that the absolute value of the impedance of the inductor L2 becomes larger as the frequency of the input signal becomes higher. Further, it is clear from the alternating long and short dashed line ZR2 that at frequencies less than or equal to the cut-off frequency, the absolute value of the impedance of the resistor R2 is greater than that of the impedance of the inductor L2, but is nearly constant regardless of the frequency of the input signal. Therefore, the difference between the absolute values of both the impedances becomes smaller as the frequency of the input signal becomes higher.

Further, it is clear from the solid line Z5 that the absolute value of the impedance of the series circuit 4 decreases as the frequency of the input signal becomes higher. Therefore, the absolute value of the impedance of the series circuit 4 has a smaller difference between itself and the absolute value of the impedance of the inductor L2 than that between itself and the absolute value of the impedance of the resistor R2.

Because the difference between the absolute values of the impedances of the inductor L2 and the series circuit 4 is smaller, the absolute value of the impedance of the resistor R2, which is shown by the alternating long and short dashed line ZR2, or the absolute value of the impedance of the series circuit 4, which is shown by the solid line Z5, looks small relatively. As a result, especially in the high frequency range outside the used frequency band C, the power passing through the resistor R2 or the series circuit 4 becomes large, and the amplification characteristic is stabilized.

Because the difference between the absolute value of the impedance of the third feedback circuit FB3 and that of the impedance of the second feedback circuit FB2 becomes smaller as the frequency of the input signal becomes higher, as mentioned above, the feedback amplifier according to Embodiment 1 can provide only the high frequency side with a loss.

As mentioned above, the feedback amplifier 1 according to Embodiment 1 includes: the amplification transistor T; the first feedback circuit FB1 to provide negative feedback between the gate and drain terminals of the amplification transistor T; the second feedback circuit FB2 to provide positive feedback between the gate and drain terminals of the amplification transistor T; and the third feedback circuit FB3 connected in series to the first feedback circuit FB1 and connected in parallel to the second feedback circuit FB2, to adjust the stability factor of the feedback amplifier 1 in the high frequency range outside the used frequency band.

Because the positive feedback is provided in the used frequency band by the second feedback circuit FB2, and the stability factor of the feedback amplifier 1 in the high frequency range outside the used frequency band is adjusted by the third feedback circuit FB3 in such a way as to have a desired value, the feedback amplifier 1 can provide a high-gain low-noise-index characteristic and prevent its amplification characteristic from becoming unstable in the high frequency range.

In the feedback amplifier 1 according to Embodiment 1, the first feedback circuit FB1 includes an element having a resistive property. The element having a resistive property included in the first feedback circuit FB1 can provide negative feedback between the gate and drain terminals of the amplification transistor T.

In the feedback amplifier 1A according to Embodiment 1, the first feedback circuit FB1 is the series circuit in which the resistor R1 and the capacitor C1 are connected in series. The resistor R1 which is an element having a resistive property can provide negative feedback between the gate and drain terminals of the amplification transistor T. Further, the capacitor C1 can block a direct current flowing between the gate and drain terminals of the amplification transistor T.

In the feedback amplifier 1 according to Embodiment 1, the third feedback circuit FB3 includes an element having a resistive property. By providing a loss in the high frequency range outside the used frequency band using the element having a resistive property, the amplification characteristic can be stabilized.

In the feedback amplifier 1 according to Embodiment 1, the second feedback circuit FB2 includes an element having a reactive property. By providing positive feedback, the element having a reactive property can provide a characteristic in which the stability factor becomes flat as the frequency of the input signal becomes higher in a frequency range outside the used frequency band.

In the feedback amplifier 1A or 1B according to Embodiment 1, the absolute value of the impedance in the third feedback circuit FB3 is larger than that of the impedance in the second feedback circuit FB2 at frequencies less than or equal to the cut-off frequency, and the difference between the absolute values of both the impedances becomes smaller as the frequency of the input signal becomes higher. As a result, because the third feedback circuit FB3 provides a loss mainly in the high frequency range outside the used frequency band, its amplification characteristic in the high frequency range outside the used frequency band can be stabilized.

In the feedback amplifier 1A or 1B according to Embodiment 1, the second feedback circuit FB2 is the inductor L2 connected in series between the drain terminal of the amplification transistor T and the output terminal 3. The absolute value of the impedance of the inductor L2 increases as the frequency of the input signal becomes higher. As a result, the difference between the absolute value of the impedance in the second feedback circuit FB2 and that of the impedance in the third feedback circuit FB3 can be made smaller as the frequency of the input signal becomes higher.

In the feedback amplifier 1A or 1B according to Embodiment 1, the absolute value of the impedance in the third feedback circuit FB3 decreases as the frequency of the input signal becomes higher. As a result, the difference between the absolute value of the impedance in the second feedback circuit FB2 and that of the impedance in the third feedback circuit FB3 can be made smaller as the frequency of the input signal becomes higher.

In the feedback amplifier 1A according to Embodiment 1, the second feedback circuit FB2 is the inductor L2 connected in series between the drain terminal of the amplification transistor T and the output terminal 3. The second feedback circuit FB2 resonates in series with the output capacitance Cds in a high frequency range within the used frequency band. As a result, the phase of the high frequency signal inputted to the input terminal 2 is brought close to that of the high frequency signal outputted from the output terminal 3 in the feedback amplifier 1A, and the gain of the feedback amplifier 1A rises and the noise figure of the feedback amplifier 1A can be reduced.

### Embodiment 2.

FIG. 8 is a circuit diagram showing the configuration of a feedback amplifier 1C according to Embodiment 2. The feedback amplifier 1C amplifies a high frequency signal inputted to an input terminal 2, and outputs the signal amplified thereby from an output terminal 3. The feedback amplifier 1C is a MMIC amplifier, for example. The feedback amplifier 1C includes a resistor R1, a resistor R2, a resistor R3, a capacitor C1, a capacitor C2, an inductor L1, an inductor L2, an amplification transistor T1, and an amplification transistor T2, as shown in FIG. 8. A signal having a frequency within a used frequency band is inputted to the input terminal 2.

The amplification transistor T1 has a control terminal, a first terminal, and a second terminal, and an electrical connection between the first and second terminals is made by a DC voltage inputted to the control terminal. In the amplification transistor T1, the first terminal is grounded via the inductor L1, and the second terminal is connected to a first terminal of the amplification transistor T2. For example, in the case where the amplification transistor T1 is an FET, the control terminal is a gate terminal, the first terminal is a source terminal, and the second terminal is a drain terminal. Further, the FET used as the amplification transistor T1 is a high withstand voltage one having a source field plate, such as a GaN-HEMT, for example.

The amplification transistor T2 has a control terminal, the first terminal, and a second terminal, and an electrical connection between the first and second terminals is made by a DC voltage inputted to the control terminal. The control terminal of the amplification transistor T2 is grounded via the capacitor C2, and a control voltage is supplied, via the resistor R3, to the control terminal. The first terminal of the amplification transistor T2 is connected to the second terminal of the amplification transistor T1, and the second terminal is connected, via the inductor L2 which is a second feedback circuit FB2, to the output terminal 3 and is connected, via the resistor R2 which is a third feedback circuit FB3, to the capacitor C1 included in a first feedback circuit FB1.

For example, in the case where the amplification transistor T2 is an FET, the control terminal is a gate terminal, the first terminal is a source terminal, the second terminal is a drain terminal, and an electrical connection between the source and drain terminals is made by a gate voltage Vg (control voltage) supplied to the gate terminal. Further, the FET used as the amplification transistor T2 is a high withstand voltage one having a source field plate, such as a GaN-HEMT, for example.

The amplification transistor T2 is a gate grounded transistor which is cascode-connected to the amplification transistor T1. In the amplification transistor T2, a voltage across a capacitance occurring between the gate and source terminals is made to change by changing a gate grounded capacitance. Therefore, the feedback amplifier 1C having the amplification transistor T2 can provide a gain which is high compared to that of a feedback amplifier having only a source grounded transistor (amplification transistor T).

Although the feedback amplifier 1C having the single amplification transistor T2 is shown in FIG. 8, the feedback amplifier 1C may include two or more amplification transistors T2.

For example, in the case where two or more amplification transistors T2 are included, the source and drain terminals of adjacent ones of these amplification transistors T2 are connected in order (connected in series). The source terminal of the amplification transistor T2 which is located at an end of a series circuit in which the amplification transistors T2 are connected in series is connected to the drain terminal of the amplification transistor T1, and the drain terminal of the amplification transistor T2 which is located at the other end of the above-mentioned series circuit is connected to the inductor L2 and the resistor R2.

The feedback amplifier 1C which is a MMIC may be a multistage amplifier in which two or more FETs are cascade-connected via a matching circuit.

In the feedback amplifier 1C, the first feedback circuit FB1 is a series circuit in which the resistor R1 and the capacitor C1 are connected in series. As the resistor R1, a resistor having a resistance value which causes the input and output impedances of the feedback amplifier 1C to have proper values is used in order to improve the reflection characteristic of the input and output of the feedback amplifier 1C, like in the case of the feedback amplifier 1A. Further, in order to sufficiently provide a feedback amount in a low frequency range within a used frequency band, a capacitor having an impedance value which is approximately 1/10th or less that of the resistor R1 is used as the capacitor C1.

Further, the capacitor C1 is used as a DC cut one which blocks a direct current flowing between the gate and drain terminals of the amplification transistor T1. The feedback amplifier 1C does not need to include the capacitor C1 as long as there is no influence on the DC bias of the amplification transistor T1, i.e., as long as the direct current flowing between the gate and drain terminals falls within an allowable range.

As the inductor L2, an inductor having an inductance value which brings the phase of the high frequency signal inputted to the input terminal 2 close to that of the high frequency signal outputted from the output terminal 3 in a high frequency range outside the used frequency band is used. The inductor L2 provides positive feedback, as shown by a dashed arrow A3 in FIG. 8, so that the gain of the feedback amplifier 1C is adjusted.

For example, as the inductor L2, an inductor having an inductance value at which the inductor resonates in series with the output capacitance Cds of the amplification transistor T2 at frequencies from 0.8 times to 1.2 times the frequency at a high frequency side end of the used frequency band is used. By using the inductor L2, the phase of the high frequency signal inputted to the input terminal 2 is brought close to that of the high frequency signal outputted from the output terminal 3 in the feedback amplifier 1C, and the gain of the feedback amplifier 1C rises and the noise figure of the feedback amplifier 1C is reduced.

The inductance value of the inductor L2 is larger than that of the inductor L1 connected to the source terminal of the amplification transistor T1.

The resistor R2 is used in order to adjust the stability factor of the feedback amplifier 1C in the high frequency range outside the used frequency band, as shown by an alternating long and short dashed arrow B3 in FIG. 8, with being placed between the drain terminal of the amplification transistor T2 and the capacitor C1, in a series circuit in which the amplification transistor T1 and the amplification transistor T2 are connected in series. For example, as the resistor R2, a resistor having a resistance value which causes the stability factor of the feedback amplifier 1C to have a desired value in the high frequency range outside the used frequency band is used.

Also in the feedback amplifier 1C, although there occurs a loss due to the resistor R2 which is the third feedback circuit FB3, the loss is eliminated by the effect of the inductor L2, and the feedback amplifier 1C has a noise figure as shown by the solid line NF2 shown in FIG. 5. By thus providing the feedback amplifier 1C with a loss in the high frequency range outside the used frequency band, the amplification characteristic of the feedback amplifier 1C is stabilized, and, by decreasing the loss in the used frequency band C, the gain in the used frequency band of the feedback amplifier 1C is improved and the gain flatness the feedback amplifier 1C can be ensured.

Because the feedback amplifier 1C has the components shown in FIG. 8, the feedback amplifier 1C provides a stability factor frequency characteristic shown by the solid line K3, a gain frequency characteristic shown by the solid line G2, a noise figure frequency characteristic shown by the solid line NF2, and an absolute-value-of-impedance frequency characteristic shown by the solid line Z5.

Further, the third feedback circuit FB3 which the feedback amplifier 1C includes may be a series circuit 4 of a resistor R2 and a transmission line TL1, like the feedback amplifier 1B shown in FIG. 6. The absolute value of the impedance of the series circuit 4 decreases as the frequency of an input signal becomes higher, as shown by the solid line Z5 shown in FIG. 7. Therefore, the absolute value of the impedance of the series circuit 4 has a smaller difference between itself and the absolute value of the impedance of the inductor L2 than that between itself and the absolute value of the impedance of the resistor R2. Because the difference between the absolute values of the impedances of the inductor L2 and the series circuit 4 is smaller, the power passing through the series circuit 4 becomes large in the high frequency range outside the used frequency band, and the amplification characteristic is stabilized.

As mentioned above, the feedback amplifier 1C according to Embodiment 2 includes the amplification transistor T2 which has the gate terminal, which is grounded via the capacitor C2 and is connected via the resistor R3 to a power supply, the source terminal, and the drain terminal, and in which the conductance between the source and drain terminals is controlled by the DC voltage inputted to the gate terminal. The amplification transistor T2 is connected in series to the amplification transistor T1. The drain terminal of the amplification transistor T1 is connected via the amplification transistor T2 to the inductor L2. Because the feedback amplifier 1C includes the amplification transistor T1 and the amplification transistor T2 which are cascode-connected, the feedback amplifier 1C provides a gain which is high compared to that of the feedback amplifier 1A or 1B. In addition, the feedback amplifier 1C provides a high-gain low-noise-index characteristic and can prevent its amplification characteristic from becoming unstable in the high frequency range, like the feedback amplifier 1, 1A, or 1B.

Although the case in which the feedback amplifier according to any of Embodiments 1 and 2 is a GaN-MMIC is shown, the feedback amplifier may have a configuration in which the substrate material is changed to GaAs or the like or a configuration of employing a discrete part or the like instead of a MMIC.

In Embodiments 1 and 2, although the feedback amplifier in which the first terminal (source terminal) of the amplification transistor is grounded via the inductor L1 is shown, the inductor L1 is not indispensable, and the source terminal may be grounded, not via the inductor L1. Further, as the amplification transistor, a self bias circuit may be used.

In Embodiments 1 and 2, although the case in which the amplification transistor T, T1, or T2 is an FET is shown, the amplification transistor T, T1, or T2 may be a bipolar junction transistor. In this case, the control terminal is a base terminal, the first terminal is an emitter terminal, and the second terminal is a collector terminal.

### INDUSTRIAL APPLICABILITY

The feedback amplifier according to the present disclosure can be used for wireless communication devices, for example.

### REFERENCE SIGNS LIST

1, 1A, 1B, and 1C: Feedback amplifier, 2: Input terminal, 3: Output terminal, 4: Series circuit, C1 and C2: Capacitor, Cds: Output capacitance, FB1: First feedback circuit, FB2: Second feedback circuit, FB3: Third feedback circuit, L1 and L2: Inductor, R1, R2, and R3: Resistor, T, T1, and T2: Amplification transistor, and TL1: Transmission line.

## Claims

1. A feedback amplifier (1B) comprising:
an amplification transistor (T) which has a control terminal connected to an input terminal (2), and has a first terminal and a second terminal, and in which conductance between the first and second terminals is controlled by a DC voltage inputted to the control terminal, and the first terminal is grounded;
a first feedback circuit (FB1) to provide negative feedback between the control and second terminals of the amplification transistor (T), wherein the first feedback circuit (FB1) includes an element having a resistive property, wherein the first feedback circuit (FB1) is a series circuit in which a first resistor (R1) and a capacitor (C1) are connected in series;
a second feedback circuit (FB2) provided between an output terminal (3) and the second terminal of the amplification transistor (T), and connected in series to the first feedback circuit (FB1), to provide, via the first feedback circuit (FB1), positive feedback between the control and second terminals of the amplification transistor (T), wherein the second feedback circuit (FB2) includes an element having a reactive property, wherein the second feedback circuit (FB2) is an inductor (L2) connected in series between the second terminal of the amplification transistor (T) and the output terminal (3), and the absolute value of the impedance in the second feedback circuit (FB2) increases as the frequency of the input signal becomes higher; and
a third feedback circuit (FB3) including a second resistor (R2) and a transmission line (TL1) conected in series,
the third feedback circuit being connected in series to the first feedback circuit (FB1) and connected in parallel to the second feedback circuit (FB2), to adjust a stability factor of the feedback amplifier (1B) in a high frequency range outside a used frequency band, wherein the third feedback circuit (FB3) includes an element having a resistive property, wherein the absolute value of the impedance in the third feedback circuit (FB3) is greater than that of an impedance in the second feedback circuit (FB2), at frequencies less than or equal to a cut-off frequency, and a difference between the absolute values of both the impedances becomes smaller as the frequency of the input signal becomes higher, wherein an absolute value of an impedance in the third feedback circuit (FB3) decreases as a frequency of an input signal becomes higher.

2. The feedback amplifier (1B) according to claim 1, wherein the second feedback circuit (FB2) resonates in series with output capacitance in a high frequency range within the used frequency band.

3. The feedback amplifier (1B) according to claim 1 or 2, further comprising one or more transistors (T2) each of which has a control terminal grounded via a capacitor (C2) and connected via a resistor (R3) to a power supply, and has a first terminal and a second terminal, and in each of which conductance between the first and second terminals is controlled by a DC voltage inputted to the control terminal, wherein the one or more transistors (T2) are connected in series to the amplification transistor (T1) and the second terminal of the amplification transistor (T1) is connected via the one or more transistors (T2) to the second feedback circuit (FB2).

## Patentansprüche

1. Rückkopplungsverstärker (1B), umfassend:
einen Verstärkungstransistor (T), welcher einen Steueranschluss aufweist, der mit einem Eingangsanschluss (2) verbunden ist, und einen ersten Anschluss und einen zweiten Anschluss aufweist, und in welchem eine Leitfähigkeit zwischen dem ersten und dem zweiten Anschluss durch eine an den Steueranschluss angelegte Gleichspannung geregelt wird, und der erste Anschluss geerdet ist;
eine erste Rückkopplungsschaltung (FB1), um eine negative Rückkopplung zwischen dem Steueranschluss und dem zweiten Anschluss des Verstärkungstransistors (T) bereitzustellen, wobei die erste Rückkopplungsschaltung (FB1) ein Element mit einer resistiven Eigenschaft umfasst, wobei die erste Rückkopplungsschaltung (FB1) eine Reihenschaltung ist, in der ein erster Widerstand (R1) und ein Kondensator (C1) in Reihe geschaltet sind;
eine zweite Rückkopplungsschaltung (FB2), die zwischen einem Ausgangsanschluss (3) und dem zweiten Anschluss des Verstärkungstransistors (T) bereitgestellt ist, und mit der ersten Rückkopplungsschaltung (FB1) in Reihe geschaltet ist, um über die erste Rückkopplungsschaltung (FB1) eine positive Rückkopplung zwischen dem Steueranschluss und dem zweiten Anschluss des Verstärkungstransistors (T) bereitzustellen, wobei die zweite Rückkopplungsschaltung (FB2) ein Element mit einer reaktiven Eigenschaft umfasst, wobei die zweite Rückkopplungsschaltung (FB2) eine Induktivität (L2) ist, die zwischen dem zweiten Anschluss des Verstärkungstransistors (T) und dem Ausgangsanschluss (3) in Reihe geschaltet ist, und der Absolutwert der Impedanz in der zweiten Rückkopplungsschaltung (FB2) zunimmt, je höher die Frequenz des Eingangssignals wird; und
eine dritte Rückkopplungsschaltung (FB3), die einen zweiten Widerstand (R2) und eine Übertragungsleitung (TL1) umfasst, die in Reihe geschaltet sind, wobei die dritte Rückkopplungsschaltung mit der ersten Rückkopplungsschaltung (FB1) in Reihe geschaltet ist und mit der zweiten Rückkopplungsschaltung (FB2) parallel geschaltet ist, um einen Stabilitätsfaktor des Rückkopplungsverstärkers (1B) in einem Hochfrequenzbereich außerhalb eines genutzten Frequenzbandes anzupassen, wobei die dritte Rückkopplungsschaltung (FB3) ein Element mit einer resistiven Eigenschaft umfasst, wobei der Absolutwert der Impedanz in der dritten Rückkopplungsschaltung (FB3) größer ist als der einer Impedanz in der zweiten Rückkopplungsschaltung (FB2) und bei Frequenzen, die kleiner oder gleich einer Grenzfrequenz sind, und eine Differenz zwischen den Absolutwerten beider Impedanzen kleiner wird, je höher die Frequenz des Eingangssignals wird,
wobei ein Absolutwert einer Impedanz in der dritten Rückkopplungsschaltung (FB3) abnimmt, je höher die Frequenz eines Eingangssignals wird.

2. Rückkopplungsverstärker (1B) nach Anspruch 1, wobei
die zweite Rückkopplungsschaltung (FB2) mit der Ausgangskapazität in einem hohen Frequenzbereich innerhalb des genutzten Frequenzbandes in Reihe mitschwingt.

3. Rückkopplungsverstärker (1B) nach Anspruch 1 oder 2, ferner umfassend einen oder mehrere Transistoren (T2), von denen jeder einen Steueranschluss aufweist, der über einen Kondensator (C2) geerdet ist, und über einen Widerstand (R3) mit einer Energieversorgung verbunden ist, und einen ersten Anschluss sowie einen zweiten Anschluss aufweist, wobei in jedem davon eine Leitfähigkeit zwischen dem ersten und dem zweiten Anschluss durch eine an den Steueranschluss angelegte Gleichspannung geregelt wird,
wobei der eine oder die mehreren Transistoren (T2) mit dem Verstärkungstransistor (T1) in Reihe geschaltet sind, und der zweite Anschluss des Verstärkungstransistors (T1) über den einen oder die mehreren Transistoren (T2) mit der zweiten Rückkopplungsschaltung (FB2) verbunden ist.

## Revendications

1. Un amplificateur à rétroaction (1B) comprenant :
un transistor d'amplification (T) qui a une borne de commande connectée à une borne d'entrée (2), et a une première borne et une seconde borne, et dans lequel une conductance entre les première et seconde bornes est commandée par une tension continue appliquée à la borne de commande, et la première borne est mise à la terre ;
un premier circuit de rétroaction (FB1) pour fournir une rétroaction négative entre les bornes de commande et seconde du transistor d'amplification (T), dans lequel le premier circuit de rétroaction (FB1) inclut un élément ayant une propriété résistive, dans lequel le premier circuit de rétroaction (FB1) est un circuit en série dans lequel une première résistance (R1) et un condensateur (C1) sont connectés en série ;
un deuxième circuit de rétroaction (FB2) prévu entre une borne de sortie (3) et la seconde borne du transistor d'amplification (T), et connecté en série au premier circuit de rétroaction (FB1), pour fournir, via le premier circuit de rétroaction (FB1), une rétroaction positive entre les bornes de commande et seconde du transistor d'amplification (T), dans lequel le deuxième circuit de rétroaction (FB2) inclut un élément ayant une propriété réactive, dans lequel le deuxième circuit de rétroaction (FB2) est une inductance (L2) connectée en série entre la seconde borne du transistor d'amplification (T) et la borne de sortie (3), et la valeur absolue de l'impédance dans le deuxième circuit de rétroaction (FB2) augmente à mesure que la fréquence du signal d'entrée devient plus élevée ; et
un troisième circuit de rétroaction (FB3) incluant une deuxième résistance (R2) et une ligne de transmission (TL1) connectées en série, le troisième circuit de rétroaction étant connecté en série au premier circuit de rétroaction (FB1) et connecté en parallèle au deuxième circuit de rétroaction (FB2), pour ajuster un facteur de stabilité de l'amplificateur à rétroaction (1B) dans une plage de hautes fréquences à l'extérieur d'une bande de fréquences utilisée, dans lequel le troisième circuit de rétroaction (FB3) inclut un élément ayant une propriété résistive, dans lequel la valeur absolue de l'impédance dans le troisième circuit de rétroaction (FB3) est supérieure à celle d'une impédance dans le deuxième circuit de rétroaction (FB2), à des fréquences inférieures ou égales à une fréquence de coupure, et une différence entre les valeurs absolues des deux impédances devient plus petite à mesure que la fréquence du signal d'entrée devient plus élevée,
dans lequel une valeur absolue d'une impédance dans le troisième circuit de rétroaction (FB3) diminue à mesure qu'une fréquence d'un signal d'entrée devient plus élevée.

2. Amplificateur à rétroaction (1B) selon la revendication 1, dans lequel
le deuxième circuit de rétroaction (FB2) résonne en série avec une capacité de sortie dans une plage de hautes fréquences à l'intérieur de la bande de fréquences utilisée.

3. Amplificateur à rétroaction (1B) selon la revendication 1 ou 2, comprenant en outre au moins un transistor (T2), chacun desquels a une borne de commande mise à la terre via un condensateur (C2) et connectée via une résistance (R3) à une alimentation électrique, chacun ayant en outre une première borne et une seconde borne, une conductance respective entre la première et la seconde borne étant commandée par une tension continue appliquée à la borne de commande,
dans lequel l'au moins un transistor (T2) est connecté en série au transistor d'amplification (T1) et la seconde borne du transistor d'amplification (T1) est connectée via les un ou plusieurs transistors (T2) au deuxième circuit de rétroaction (FB2).
